Europäisches Patentamt

(19) European Patent Office

Office européen des brevets

(11) Numéro de publication: **0 014 607**
**B1**

(12) FASCICULE DE BREVET EUROPEEN

(45) Date de publication du fascicule du brevet: **17.11.82**

(51) Int. Cl.³: **G 02 B 7/26, H 01 L 31/02**

(21) Numéro de dépôt: **80400059.4**

(22) Date de dépôt: **15.01.80**

(54) Tête de couplage opto-électronique.

(30) Priorité: **08.02.79 FR 7903226**

(43) Date de publication de la demande:
**20.08.80 Bulletin 80/17**

(45) Mention de la délivrance du brevet:
**17.11.82 Bulletin 82/46**

(84) Etats contractants désignés:
**DE GB IT NL**

(56) Documents cités:
**FR - A - 2 313 688**
**US - A - 3 423 594**
**US - A - 3 954 338**

(73) Titulaire: **THOMSON-CSF**
**173, Boulevard Haussmann**
**F-75379 Paris Cedex 08 (FR)**

(72) Inventeur: **Henry, Raymond**
**"THOMSON-CSF" - SCPI 173, bld Haussmann**
**F-75360 Paris Cedex 08 (FR)**
Inventeur: **Simon, Jacques**
**"THOMSON-CSF" - SCPI 173, bld Haussmann**
**F-75360 Paris Cedex 08 (FR)**

(74) Mandataire: **Giraud, Pierre et al,**
**THOMSON-CSF SCPI 173, Bld Haussmann**
**F-75379 Paris Cedex 08 (FR)**

Courier Press, Leamington Spa, England.

Tête de couplage opto-électronique

L'invention concerne une tête de couplage optoélectronique qui peut être soit une tête d'émission soit une tête de réception (ou détection), éventuellement une tête mixte (émission ou réception).

On sait qu'une liaison de télécommunication par fibre optique peut comporter:

— une tête d'émission comportant un émetteur optique modulé par l'information à transmettre, émetteur qui est par exemple une diode électroluminescente ou une diode laser, couplé avec un tronçon de fibre optique;

— au moins un connecteur couplant le tronçon de fibre optique avec une ou plusieurs fibres optiques;

— au moins un câble optique comprenant un nombre variable de fibres dont une ou plusieurs sont affectées à la transmission de l'information provenant de l'émetteur;

— au moins un connecteur couplant la ou les fibres optiques intéressées par la transmission dont il s'agit avec un tronçon de fibre optique;

— une tête de réception (ou de détection) comportant un tronçon de fibre optique couplé avec un récepteur (ou détecteur) optique (photodiode) restituant l'information sous forme électrique.

Une tête mixte comporterait un composant susceptible de fonctionner comme émetteur ou récepteur suivant le sens de la polarisation du composant.

Une liaison complète comporte une liaison de type ci-dessus dans chaque sens de transmission.

La réalisation d'une tête d'émission ou de réception pose des problèmes:

— d'ordre mécanique, car il faut assurer un positionnement et l'immobilisation, dans la position optimale, du composant opto-électronique (émetteur ou récepteur) par rapport à la surface terminale (d'entrée ou de sortie) du tronçon de fibre optique;

— d'ordre électrique et d'optique, en ce qui concerne notamment l'étanchéité des composants de manière à assurer et à préserver un bon isolement électrique des constituants de la tête, et les qualités optiques ou opto-électroniques.

Les solutions connues sont, soit des réalisations complexes d'un coût élevé de fabrication, soit des réalisations beaucoup plus simples mais ne donnant pas la précision de positionnement à l'aide d'une réalisation d'une grande simplicité et d'un prix de revient modéré.

On connaît, par le document US—A—3 423 594, une tête de couplage opto-électronique comprenant un dispositif-support du composant opto-électronique, le composant opto-électronique lui-même, un dispositif de positionnement de fibre optique, un tronçon constitué par une fibre optique ou par un faisceau de fibres optiques enfin un dispositif d'encapsulation comportant une embase et au moins un capot. Dans les différentes variantes de réalisation de cette tête de couplage, on trouve, en tout cas, au moins une enveloppe cylindrique métallique servant de dispositif d'encapsulation. Dans cette enveloppe est fixée une coupelle percée en son centre et comprenant des moyens de centrage de la fibre optique ou d'un faisceau de fibres d'une part, et, d'autre part, du composant opto-électronique. Ces différents moyens sont fixes et ne permettent aucun réglage en fonctionnement, ce qui constitue un inconvénient notable.

L'invention présente l'avantage de permettre la séparation en deux phases indépendantes de deux opérations nécessaires à la fabrication de la tête, à savoir le réglage de la position du composant optoélectronique par rapport à la fibre optique, et la finition de l'étanchéité de la tête.

La tête de couplage opto-électronique suivant l'invention est du type comprenant un dispositif-support du composant opto-électronique, le composant opto-électronique lui-même, un dispositif de positionnement de fibre optique dit porte-fibre, un tronçon de fibre optique, enfin un dispositif d'encapsulation comportant une embase et un capot.

· Elle est caractérisée en ce que l'extrémité du porte-fibre située du côté du composant électronique, comporte un système de cales solidaires du porte-fibre définissant par leurs faces coplanaires un plan d'appui du dispositif-support du composant opto-électronique, en ce que l'embase est constituée par le porte-fibre lui-même, et en ce que le dispositif-support est fixé à ces faces coplanaires.

L'invention sera mieux comprise au moyen de la description qui suit, et des dessins qui l'accompagnent, parmi lesquels: ·

— la figure 1 représente un dispositif-support de composant électronique muni d'un composant équipé de connexions électriques et la figure 2 représente un porte-fibre équipé d'un système de cales conforme à l'invention;

— la figure 3 représente en coupe schématique un exemple de réalisation de l'invention.

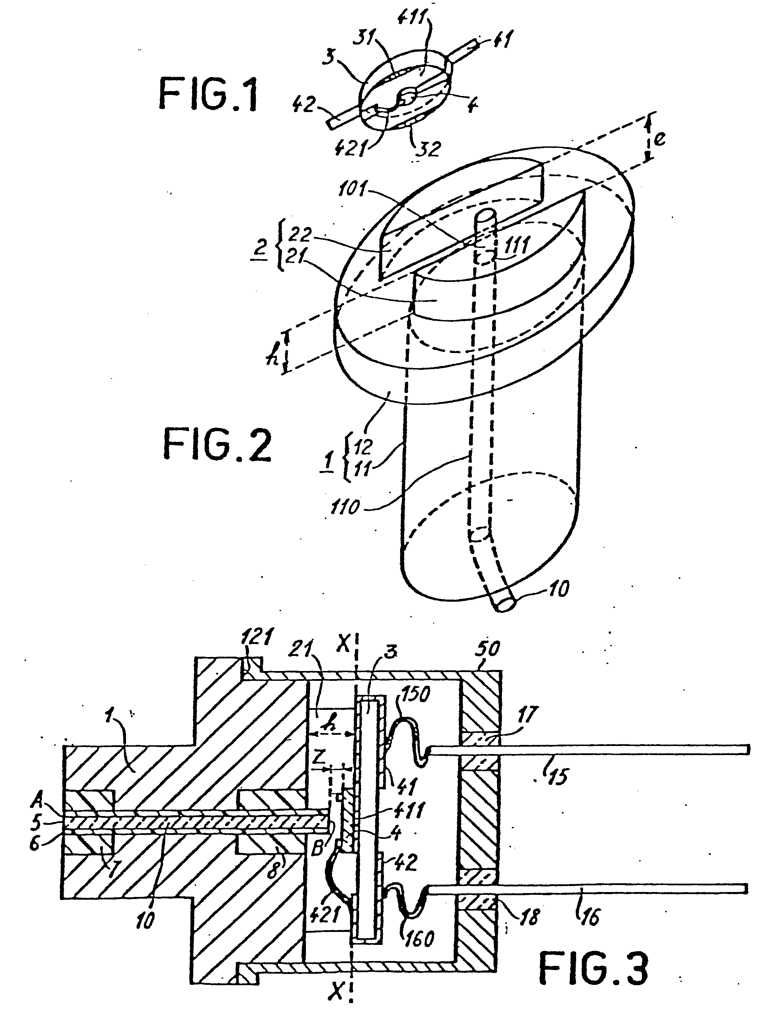

Un porte-fibre 1 est représenté en perspective figure 2. Il est très simplifié par rapport à la réalisation donnée à titre d'exemple figure 3. Il comporte un mandrin cylindrique 11 percé suivant son axe d'un évidement cylindrique 110 contenant une fibre optique 10. Le mandrin est abouté à un plateau cylindrique 12 de même axe, comportant un orifice axial 111 de même diamètre que le logement 110. De cet orifice émerge l'extrémité 101 de la fibre 10. Un système 2 de deux cales symétriques 21 et 22 est soudé au plateau 12 de part et d'autre de la fibre. L'écartement e de ces cales est compris entre deux limites qui sont respectivement le diamètre du support 3 (voir figure 1) du composant opto-électronique 4 et la plus grande dimension de ce composant. Cet écartement est nécessaire pour laisser un espace suffisant à la fibre, au composant opto-électronique et aux connexions de raccordement électrique de celui-ci. Pour clarifier le dessin, les connexions 41 et 42 du composant sont représentées comme de simples bandes conductrices coudées vers le bas au moment où elles atteignent le bord du support 3, puis rabattues parallèlement à une grande face du support 3, alors qu'en réalité (voir figure 3) elles sont appliquées contre la face libre de ce support. L'une des connexions, 41 par exemple, est une métallisation gravée sur la face 411 du support et sur laquelle est soudée la face inférieure métallisée du composant 4. La connexion 42 comporte un fil souple 421 partant de l'électrode du composant. Le support 3 est par exemple en céramique. L'épaisseur $h$ des cales est plus grande que celle du composant 4, par exemple de l'ordre de trois à quatre fois cette dernière. Le support isolant 3 comporte deux plages métallisées 31 et 32, facilitant la soudure du support sur les cales. Celles-ci sont soit métalliques et soudées au porte-fibre 1, lui-même métallique, soit isolantes et par exemple partie entégrante d'un corps en matière plastique obtenu par moulage et comportant les pièces 1 et 2. Dans ce dernier cas, les faces des cales définissant le plan d'appui du support sont elles aussi métallisées pour faciliter les soudures avec les plages métallisées du support 3.

On a représenté figure 3 une tête opto-électronique montée et encapsulée. Dans l'exemple de réalisation représenté, le mandrin et le plateau forment une seule pièce 1, par exemple en cuivre. Le plan de figure est un plan de coupe axial, parallèle aud faces en regard des cales 21 et 22. Une seule de ces faces est visible figure 2. La fibre optique 10, dont la coupe fait apparaître le coeur 5 et la gaine 6, est constituée par un tronçon de fibre optique terminé par deux faces planes A et B. La face A est coplanaire avec la face terminale du mandrin du porte-fibre. La face B est à une distance $z$ de la face active du composant 4. Le tronçon est fixé dans le conduit axial du porte-fibre grâce à des dépôts de soudure ou de résine 7 et 8, effectués dans des portions du conduit de plus grand diamètre situées aux extrémités de ce conduit. Aucun jeu mécanique n'est toléré entre fibre et porte-fibre. Le réglage complet de la tête a pour but de fixer les positions respectives du composant 4 et de la fibre 10 de façon à obtenir le meilleur rendement opto-électronique. Il comporte les opérations suivantes:

1) Avant fixation de la fibre optique dans le porte-fibre par soudure ou collage, on détermine la position de la face B par rapport au plan d'appui du support 3 sur les cales 21 et 22 (plan de trace XX figure 3). Cette détermination se fite à l'aide d'un calibre dont la dimension tient compte de l'épaisseur du composant 4 entre face active et plan XX. Le choix du calibre est effectué par tâtonnements sur un prototype de tête, puis appliqué systématiquement lors de la fabrication en série. La distance $z$ est réglée de manière à rendre optimale l'émission ou la réception de lumière par le composant opto-électronique.

2) On fixe la fibre en effectuant les dépôts 7 et 8, puis on sectionne le tronçon de fibre à l'extrémité du mandrin et on polit la face A.

3) On applique le support 3 muni du composant 4 sur les cales 21 et 22 et l'on règle la position du support dans le plan XX (réglage dit en "x, y") en alimentant le composant par des connexions provisoires et en controlant le bon fonctionnement de la tête. On repère la position du support dans le plan XX qui donne le résultat optimal.

4) On soude le support 3 aux cales 21 et 22. Sur la figure 3, la tête complète comporte en outre un capot métallique 50, équipé de deux traversées 17 et 18 par perles de verre 17 et 18. Ces traversées 15 et 16 sont des tiges rigides bonnes conductrices de l'électricité; elles sont terminées par des ressorts de contact 150 et 160 faisant pression sur les plages métallisées 41 et 42 du support 3.

Le capot 50 est soudé au porte-fibre suivant une encoche circulaire 121 de celui-ci.

Dans une variante possible de cette réalisation les connexions de raccordement aux métallisations 41 et 42 sont disposées latéralement et traversent le capot par des perles de verre placées sur la périphérie de ce dernier.

Parmi les avantages non déjà signalés de l'invention, on mentionnera que l'on peut facilement l'utiliser dans le cas:

— de fibres optiques de très grand ou de très petit diamètre, en fabriquant un porte-fibre de dimensions convenables;

— de composants opto-électroniques de très grand encombrement, en adaptant le porte-fibre, le support et le capot aux dimensions du composant; ce dernier peut être éventuellement une diode laser;

— enfin, de tronçons de fibres optiques raccordés à des connecteurs très divers.

**Revendications**

1. Tête de couplage opto-électronique, du type comprenant un dispositif-support d'un composant opto-électronique, le composant lui-même, un dispositif de positionnement de fibre optique dit porte-fibre, un tronçon de fibre optique, et un dispositif d'encapsulation comportant une embase et un capot, caractérisée en ce que l'extrémité du porte-fibre (1) située du côté du composant (4) comporte un système (2) de deux cales symétriques (21, 22) et solidaires du porte-fibre (1), définissant par leurs faces coplanaires non solidaires du porte-fibre un plan d'appui du dispositif-support du composant, en ce que l'embase (11) est constituée par le porte-fibre, et en ce que le dispositif-support (3) est fixé à ces faces coplanaires.

2. Tête de couplage suivant la revendication 1, caractérisée en ce que le composant opto-électronique (4) comporte, sur la face opposée à sa face active une métallisation soudée à une métallisation (411) préalablement formée sur le dispositif-support (3), celui-ci étant isolant et comportant, outre ladite métallisation, des plages métallisées (31, 32) permettant de souder le support aux faces d'appui des cales.

3. Tête de couplage suivant la revendication 2, caractérisée en ce que le porte-fibre (1) comporte un mandrin (11) cylindrique percé suivant son axe d'un évidement (111) cylindrique destiné à recevoir le tronçon (10) de la fibre, un plateau cylindrique (12) percé d'un évidement analogue à celui du mandrin étant abouté coaxialement à celui-ci, la périphérie du plateau (12) présentant un profil (121) adapté à celui du capot (50) afin de faciliter la soudure de celui-ci sur l'embase constituée par le porte-fibre (1).

4. Tête de couplage suivant la revendication 3, caractérisé en ce que le capot (50) est traversé par des connexions (15, 16) de raccordement électrique du composant (4) opto-électronique, les traversées étant munies de dispositifs (17, 18) assurant leur étranchéité, ledit capot (50) étant indépendant mécaniquement, du composant (4) d'une part et du tronçon de fibre (10) d'autre part.

5. Tête de couplage suivant la revendication 4, caractérisée en ce que les traversées (17, 18) étanches comportent des tiges (15, 16) conductrices munies de ressorts (150, 160) de contact appuyant sur les métallisations (41, 42) du support (3) reliées aux bornes électriques du composant (4).

Patentansprüche

1. Elektronenoptischer Kupplungskopf, mit einer einen elektronenoptischen Baubestandteil haltenden Haltevorrichtung, mit diesem Baubestandteil selbst, mit einer "Lichtleiterhalter" genannten Vorrichtung zum Einstellen eines Lichtleiters, mit einem Lichtleiterabschnitt, sowie mit einer eine Basis und eine Kappe aufweisenden Gehäusevorrichtung, dadurch gekennzeichnet, dass das dem Baubestandteil (4) zugewandte Ende des Lichtleiterhalters (1) ein System (2) aufweist, welches zwei symmetriche Keile (21, 22) besitzt, die mit dem Lichtleiterhalter (1) fest verbunden sind und deren mit dem Lichtleiterhalter nicht verbundene koplanare Flächen eine Stützebene der Baubestandteil-Haltevorrichtung bilden, dass die Basis (11) durch den Lichtleiterhalter gebildet ist, und dass die Haltevorrichtung (3) an den genannten koplanaren Flächen befestigt ist.

2. Kupplungskopf nach Anspruch 1, dadurch gekennzeichnet, dass der elektronenoptische Baubestandteil (4) an seiner seiner aktiven Fläche entgegengesetzten Fläche eine Metallisierungsschicht aufweist, die mit einer zuvor an der Haltevorrichtung (3) angebrachten Metallisierungsschicht (411) verschweisst ist, wobei diese Haltevorrichtung isolierend ist und ausser der genannten Metallisierungsschicht metallisierte Zonen (31, 32) besitzt, die das Anschweissen des Halters an die Stützflächen der Keile ermöglichen.

3. Kupplungskopf nach Anspruch 2, dadurch gekennzeichnet, dass der Lichtleiterhalter (1) einen zylindrischen Dorn (11) aufweist, der mit einer axialen Bohrung (111) zwecks Aufnahme des Lichtleiterabschnitts (10) versehen ist, ferner eine zylindrische Platte (12) aufweist, die mit einer der Bohrung des Dornes estsprechenden und koaxial an einem Ende mit derselben verbundenen Bohrung versehen ist, wobei der Umfang der Platte (12) ein dem Profil der Kappe (50) entsprechendes Profil (121) besitzt, um des Anschweissen der Kappe auf die durch den Lichtleiterhalter (1) gebildete Basis zu erleichtern.

4. Kupplungskopf nach Anspruch 3, dadurch gekennzeichnet, dass die Kappe (50) von Verbindungsteilen (15, 16) zum elektrischen Anschluss des elektronenoptischen Baubestandteils (4) durchquert ist, wobei diese Durchquerungen zwecks ihrer Abdichtung mit Dichtungsmitteln (17, 18) versehen sind, und wobei die Kappe (50) einerseits vom Baubestandteil (4) und andererseits vom Lichtleiterabschnitt (10) mechanisch unabhängig ist.

5. Kupplungskopf nach Anspruch 4, dadurch gekennzeichnet, dass die dichten Durchquerungen (17, 18) leitende Stangen (15, 16) aufweisen, die mit sich auf den mit den elecktrichen Anschlussklemmen des Baubestandteiles (4) verbundenen metallisierten Flächen (41, 42) des Halters (3) abstützenden Kontaktfedern (150, 160) versehen sind.

Claims

1. An electron-optical coupling head of the type comprising a supporting device for supporting an electronoptical component; further comprising said component itself, an optic fibre positioning device called fibre support, an optic fibre section, and a housing device comprising a base and a cap, characterized in that that end of the fibre support (1) which is located at the side of the component (4) includes a system (2) comprising two symmetrical wedges (21, 22) integrally connected to the fibre support (1), defining by their coplanar faces non-integral with the fibre support a bearing face for the component supporting device, in that the base (11) is constituted by the fibre support, and in that the supporting device (3) is fixed to said coplanar face.

2. A coupling head according to claim 1, characterized in that the electron-optical component (4) comprises on the face opposed to its active face a metallization layer welded to a metallization layer (411) previously formed on the supporting device (3), this latter device being isolating and comprising, further to said metallization layer, metallized zones (31, 32) allowing the support to be welded to the bearing faces of the wedges.

3. A coupling head according to claim 2, characterized in that the fibre support (1) comprises a cylindrical mandrel (11) provided with an axial cylindrical bore (111) adapted to receive the fibre section (10), a cylindrical plate (12) provided with a bore corresponding to that of the mandrel and connected endwise and coaxially to this latter bore, the periphery of the plate (12) having a profile (121) adapted to that of the cap (50) so as to facilitate the welding of the latter onto the base constituted by the fibre support (1).

4. A coupling head according to claim 3, characterized in that the cap (50) comprises electrical connection means (15, 16) passing through said cap and adapted to connect the electron-optical component (4), said through-connections being provided with devices (17, 18) ensuring their tightness, said cap (50) being mechanically independent of the component (4), on the one hand, and of the fibre section (10), on the other hand.

5. A coupling head according to claim 4, characterized in that the tight through-connections (17, 18) comprise conductive rods (15, 16) provided with contact springs (150, 160) engaging the metallization layers (41, 42) of the support (3) which are connected to the terminals of the component (4).

0 014 607

FIG.1

FIG.2

FIG.3